# FASCICULE DE BREVET EUROPEEN

(11) **EP 2 143 684 B1**
(45) Date de publication et mention de la délivrance du brevet: **10.04.2013**
(21) Numéro de dépôt: 09164694.3
(22) Date de dépôt: 06.07.2009
(51) Int. Cl.: B81C 1/00

(54) **Procédé de fabrication d'une structure MEMS/NEMS comportant un ancrage partiellement monocristallin**
Herstellungsverfahren von einer MEMS-/NEMS-Struktur die eine teilweise monokristalline Verankerung besitzt
Method of manufacturing a MEMS/NEMS structure comprising a partially monocrystalline anchor

(30) Priorité: 09.07.2008 FR 0854670
(43) Date de publication de la demande: 13.01.2010
(73) Titulaire: Commissariat à l'Énergie Atomique et aux Énergies Alternatives, 75015 Paris (FR)
(72) Inventeur: Robert, Philippe, 38000 Grenoble (FR)
(74) Mandataire: Ilgart, Jean-Christophe

(56) Documents cités:
- US-A1- 2005 032 266
- US-A1- 2008 108 165

## Description

### DOMAINE TECHNIQUE

L'invention se rapporte à une structure MEMS (pour « Micro-Electro-Mechanical-System ») ou NEMS (pour « Nano-Electro-Mechanical-System ») comportant au moins un ancrage servant à la fixation d'un élément flexible (poutre ou membrane). Elle se rapporte également à un procédé de réalisation d'une telle structure.

### ÉTAT DE LA TECHNIQUE

L'utilisation du silicium monocristallin pour la réalisation de composants MEMS ou NEMS est intéressante à plusieurs titres. Ses propriétés mécaniques sont excellentes, notamment par rapport au silicium polycristallin. De fortes épaisseurs peuvent être utilisées (dans le cas du silicium polycristallin, l'épaisseur est généralement limitée à 20 µm). Il possède de très bonnes propriétés piézoélectriques. Ses propriétés semiconductrices, bien connues et bien maîtrisées, permettent une ce-intégration de ces composants mécaniques avec l'électronique associée.

Dans l'état de l'art, on trouve plusieurs modes de réalisation de structures MEMS/NEMS en silicium monocristallin, c'est-à-dire des composants mécaniques libérés, à même de pouvoir se déplacer sous l'action d'une force extérieure, en technologie de surface.

La technologie SOI est la plus répandue. Dans ce cas, le composant est réalisé sur la couche active du substrat SOI et l'oxyde enterré sert à la fois de couche d'arrêt de gravure du silicium et de couche sacrificielle. La libération de la structure mécanique se fait par la face avant du substrat. Une première variante consiste à graver toute la face arrière pour libérer le composant mécanique, en s'arrêtant sur l'oxyde enterré. La libération se fait alors par la face arrière du substrat. Une deuxième variante consiste à reporter le substrat SOI sur une cavité pour le libérer par simple gravure du silicium. L'intérêt de la technologie SOI pour les MEMS repose sur l'oxyde enterré que permet à la fois :
- de servir de couche d'arrêt à la gravure du silicium, et donc de définir avec précision l'épaisseur de la couche de silicium sur laquelle sera fait le composant (quelle que soit la variante),
- de servir de couche sacrificielle (dans le cas d'un procédé face avant principalement),
- d'avoir une couche isolante électrique soutenant le composant MEMS/NEMS (pour éviter de mettre tous les éléments du MEMS ou du NEMS en court-circuit).

Par contre, le gros inconvénient de la technologie SOI est son prix élevé. On a également observé récemment des problèmes de contraintes mal contrôlées dans le SOI qui, dans certaines configurations, sont très dommageables pour les MEMS/NEMS.

Dans la technologie SON (pour "Silicon-on-Nothing"), on fait croître une couche de SiGe sur un substrat de silicium standard, et sur cette couche de SiGe, on fait croître une couche de silicium monocristallin. Le composant MEMS/NEMS est réalisé sur cette dernière couche de silicium et le SiGe sert de couche sacrificielle. Pour la libération, on utilise une gravure sèche du SiGe à base de CF₄, sélective par rapport au silicium monocristallin.

L'intérêt principal de la technologie SON, c'est qu'il s'agit d'un procédé bas coût. Cela permet également d'avoir accès à des épaisseurs de silicium très faibles (typiquement quelques 100 nm), par exemple pour les NEMS. Ses inconvénients sont par contre multiples.

La gravure isotope du SiGe est assez faiblement sélective par rapport au silicium. On est donc limité à des libérations de motifs étroits (typiquement inférieurs au µm). L'épaisseur de silicium épitaxié sur le SiGe est généralement limitée à quelques centaines de manomètres (des dislocations risquent d'apparaître si l'on souhaite obtenir de fortes épaisseurs de silicium). Le SiGe est semi-conducteur. Pour avoir des zones isolées électriquement sur le MEMS/NEMS, cela suppose de mettre une couche isolante dans les zones devant être isolées électriquement (dépôt SiO₂ ou SiN par exemple). La couche de silicium épitaxiée au-dessus de cette couche isolante sera polycristalline (et non monocristalline). Ce point peut être assez critique puisque ces zones correspondent à des zones d'ancrage où le matériau est particulièrement sollicité. Le fait d'avoir un matériau polycristallin dans ces zones d'ancrage (plutôt que monocristallin) conduit soit à avoir un moins bon facteur de qualité, dans le cas de structures résonantes, soit à être plus sensible à des contraintes mécaniques (par exemple la tenue aux ohocs).

Dans la technologie SCREAM, on part d'un substrat standard pour réaliser un composant MEMS et on utilise une partie "enterrée" du silicium massif comme couche sacrificielle. Le procédé se décompose de la manière suivante : gravure DRIE (pour "Deep Reactive Ion Etching" ou gravure ionique réactive profonde) de la structure MEMS, oxydation thermique, gravure anisotrope de l'oxyde, gravure isotrope du silicium pour libérer le MEMS, métallisation de la structure (sur les flancs et le dessus).

L'intérêt principal de la technologie SCREAM, c'est sa simplicité et son aspect bas coût.

Ses inconvénients sont par contre multiples. Il n'y a pas d'ancrage isolant. Cela se solde par la création de contraintes mécaniques importantes sur le MEMS (dus à la présence de l'oxyde thermique et du métal sur les structures libérées). Cet ajout d'oxyde et de métal sur le silicium monocristallin rend le composant mécanique moins bon (moins bon facteur de qualité dans le cas d'un résonateur par exemple). La métallisation, qui se fait après libération de la structure, nécessite l'utilisation d'un masquage mécanique lors du dépôt. Cette méthode est peu industrielle et donne une résolution des motifs très médiocre.

La technologie SCREAM procure des structures mal définies et qui se gravent sous le masque d'oxyde lors de la gravure isotrope du silicium (absence d'oxyde sous la structure à libérer).

Une autre technologie est appelée APSM (pour «Advanced Porous Silicon Membrane »). Elle est utilisée par la société BOSCH pour la fabrication de capteurs de pression. Dans ce cas, un substrat de silicium massif est rendu poreux dans les zones dédiées à la localisation des cavités. La membrane est réalisée par épitaxie de silicium sur la surface poreuse réalisée.

Le procédé de fabrication est mené de la manière suivante. La surface du substrat massif en silicium est traitée avec de l'acide fluorhydrique et soumise à une tension électrique pour obtenir une couche de silicium très poreuse (nanoporeuse). Ensuite, une couche de silicium monocristallin, destinée à former par exemple une membrane, est formée sur la couche poreuse. La couche de silicium nanoporeuse est ensuite soumise à un traitement thermique à une température de 1000°C. La couche nanoporeuse se désintègre. Il subsiste une cavité continue avec une pression de référence de moins de 1 millibar. On peut se référer à ce sujet à l'article « A novel micromachining process for the fabrication of monocrystaline Si-membranes using porous silicon » de S. ARMBRUSTER- et al., Digest of Technical Papers Transducers'03, 2003, page 246.

Comme pour la technologie SCREAM, l'inconvénient majeur de cette technologie réside dans le fait de ne pas avoir d'ancrage isolant.

Le document US 2005/0032266 A1 décrit un procédé de réalisation d'un ancrage sur un substrat. L'isolation électrique de l'ancrage est formée par une zone dopée dans le substrat.

### EXPOSÉ DE L'INVENTION

Au travers de l'état de la technique exposé ci-dessus sur les technologies MEMS/NEMS en silicium monocristallin réalisées en technologie de surface et n'utilisant pas de substrat SO1, on s'aperçoit que lorsque l'on souhaite disposer de zones d'encastrement électriquement isolées, on perd la structure monocristalline au niveau de ces ancrages (voir la technologie SON et les technologies SCREAM et APSM qui, dans leurs versions actuelles, ne comportent pas d'ancrages isolants).

Pour obtenir des ancrages monocristallins, l'idée principale de l'invention consiste à :
- réaliser les cavités d'encastrement par gravure, en laissant une « casquette », c'est-à-dire un dépassement (un surplomb) sur les bords de la cavité, en un matériau de protection monocristallin,
- combler les cavités par un matériau adéquat (par exemple SiO₂, Si₃N₄ ou d'autres matériaux isolants), la nature du matériau de remplissage étant choisie en fonction du rôle attendu de ces ancrages et de sa compatibilité avec la suite du procédé,
- former une couche de matériau semi-conducteur monocristallin (par exemple du silicium) à partir du matériau de protection monocristallin, cette couche étant destinée à servir par la suite à réaliser le composant MEMS ou NEMS.

Pour cela, lors de la gravure des encastrements, l'obtention du profil en casquette est par exemple obtenue par gravure isotrope du matériau semi-conducteur monocristallin, sélective par rapport à la couche de protection monocristalline.

La couche de protection est en matériau monocristallin autre que la couche de matériau semi-conducteur monocristallin destinée à former le composant MEMS ou NEMS. Elle permet une re-croissance de matériau semi-conducteur monocristallin par épitaxie avec une possibilité de dopage in situ de matériau ainsi épitaxié. Elle résiste à une gravure sèche ou humide du matériau du substrat ou du matériau épitaxié (gravure sélective). Eventuellement, elle peut être gravée sélectivement par rapport aux matériaux l'environnant par un procédé de gravure sèche ou humide.

Un premier objet de l'invention consiste en un procédé de réalisation d'une structure MEMS/NEMS à partir d'un substrat comportant au moins une partie en matériau semi-conducteur monocristallin, la structure comprenant un élément mécanique flexible rattaché à ladite partie du substrat par au moins une zone d'ancrage, le procédé comprenant les étapes suivantes :
- une étape de formation d'une première couche de protection en matériau monocristallin sur une face libre de ladite partie du substrat, la première couche de protection étant en un matériau différent du matériau de ladite partie en matériau semi-conducteur monocristallin du substrat,
- une étape de gravure de la première couche de protection et du substrat pour réaliser au moins une cavité, la gravure étant menée pour laisser un surplomb en matériau de la couche de protection sur les bords de la cavité,
- une étape de comblement de la cavité par un matériau électriquement isolant jusqu'à la face libre de la première couche de protection pour obtenir une partie d'ancrage isolante,
- une étape d'épitaxie comprenant l'épitaxie d'un matériau semi-conducteur à partir de la première couche de protection et du matériau électriquement isolant pour obtenir une couche destinée à la réalisation de l'élément mécanique flexible, la couche épitaxiée étant monocristalline sur la première couche de protection et polycristalline sur le matériau électriquement isolant,
- une étape de libération de l'élément mécanique flexible par gravure, à travers un masque, d'au moins la première couche de protection, la gravure laissant subsister au moins une partie dudit surplomb. On entend par élément mécanique flexible tout élément suspendu capable de se déformer. Cette déformation peut être induite par exemple par une excitation extérieure.

Selon un mode de réalisation, le procédé comprend en outre les étapes suivantes :
- formation d'une couche d'arrêt à une opération de planarisation, sur la première couche de protection, avant l'étape de gravure de la première couche de protection,
- gravure de la couche d'arrêt pour réaliser la cavité,
- comblement de la cavité faisant que le matériau électriquement isolant déborde de la face libre de la première couche de protection,
- opération de planarisation est effectuée jusqu'à exposer la face libre de la première couche de protection.

L'opération de planarisation peut comprendre un polissage mécano-chimique avec arrêt sur la couche d'arrêt suivi d'une gravure de la couche d'arrêt et du matériau comblant la cavité jusqu'à exposer la face libre de la première couche de protection.

L'étape de libération peut comprendre, sur le matériau semi-conducteur épitaxié à partir de la première couche de protection et du matériau électriquement isolant :
- la formation d'une seconde couche de protection,
- la gravure, successivement, de la seconde couche de protection, du matériau semi-conducteur épitaxié et, éventuellement, de la première couche de protection pour définir l'élément mécanique flexible, et
- la formation d'une troisième couche de protection sur l'ensemble obtenu à l'étape précédente.

La deuxième couche de protection et la troisième couche de protection peuvent être formées par dépôt ou par épitaxie. Ces deuxième et troisième couches de protection sont choisies pour ne pas être attaquées lors de la libération de l'élément mécanique.

L'étape de libération de l'élément mécanique peut comprendre en outre la formation d'une cavité dans le substrat. Elle peut aussi comprendre la gravure d'une partie de la troisième couche de protection formée sur la face du substrat.

Ladite partie du substrat peut être en silicium. La première couche de protection peut être en SiGe. Le matériau électriquement isolant peut être choisi parmi SiO₂ et Si₃N₄. Le matériau semi-conducteur épitaxié à partir de la première couche de protection peut être en silicium.

Un deuxième objet de l'invention consiste en une structure MEMS / NEMS comprenant un substrat comprenant au moins une partie en matériau semi-conducteur monocristallin et un élément mécanique flexible situé au-dessus d'une face de ladite partie du substrat, défini dans au moins une couche épitaxiée et rattaché au substrat par au moins une zone d'ancrage, la zone d'ancrage comprenant :
- une partie en matériau électriquement isolant logée dans une cavité du substrat formée à partir de la face du substrat, la partie en matériau électriquement isolant faisant saillie au-dessus de la face du substrat en formant un retrait par rapport aux bords de la cavité,
- une partie en matériau semi-conducteur monocristallin comblant au moins partiellement ledit retrait en formant un surplomb,
- une partie appartenant à la couche épitaxiée constituée de matériau polycristallin au-dessus de la saillie et de matériau monocristallin au-dessus du surplomb.

### BRÈVE DESCRIPTION DES DESSINS :

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1A à 1F illustrent les premières étapes d'une mise en oeuvre du procédé de fabrication selon la présente invention,
- la figure 2 est une vue agrandie d'un détail de la figure 1F,
- les figures 3A et 3B illustrent une variante de mise en oeuvre de la présente invention,
- les figures 4A à 4E illustrent les dernières étapes du procédé selon la présente invention, en mettant en oeuvre la technologie MON,
- la figure 5 est une vue agrandie d'un détail de la figure 4E,
- les figures 6A et 6B illustrent les dernières étapes du procédé selon la présente invention, en mettant en oeuvre la technologie SON,
- la figure 7 est une vue agrandie d'un détail de la figure 6B,
- les figures 8A et 8B illustrent les dernières étapes du procédé selon la présente invention, en mettant en oeuvre la technologie MON et utilisant un empilement de couches épitaxiées.

### DESCRIPTION DÉTAILLÉE DE MODES DE MISE EN OEUVRE DE LA PRÉSENTE INVENTION

La suite de la description va porter, à titre d'exemple non limitatif, sur la réalisation d'une structure MEMS à partir d'un substrat massif en silicium monocristallin, avec une couche de protection en SiGe monocristallin et une couche épitaxiée de silicium monocristallin.

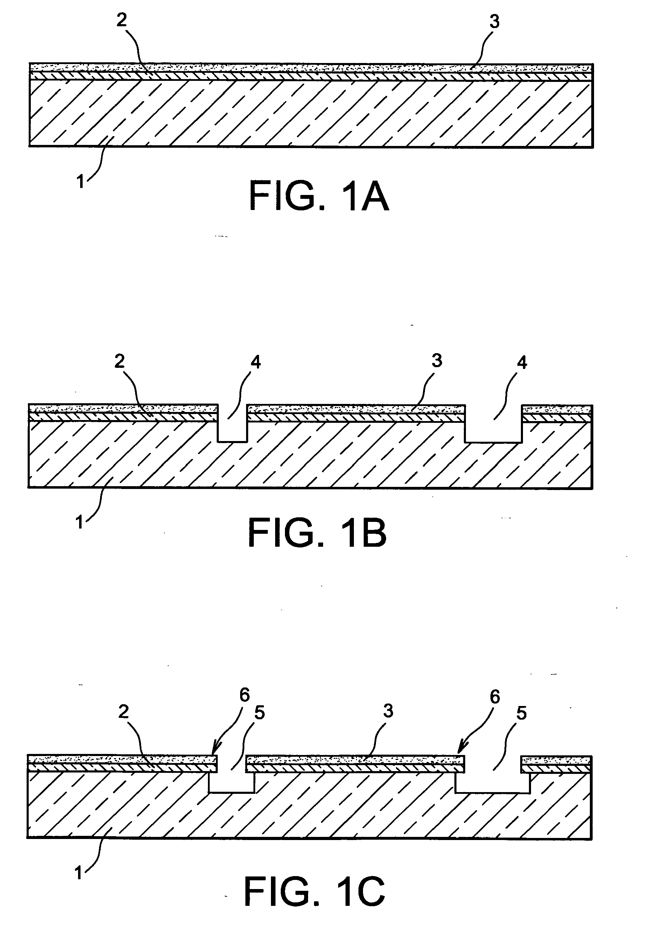

Les figures 1A à 1F sont des vues en coupe transversale illustrant les premières étapes d'une mise en oeuvre du procédé de fabrication selon la présente invention.

La figure 1A montre un substrat massif en silicium monocristallin 1 sur une face duquel on a formé, par exemple par épitaxie une couche de protection monocristalline en SiGe 2, par exemple d'une épaisseur de 70 nm et comprenant entre 20 et 30% de germanium. Sur la couche de SiGe 2, on forme de préférence une couche 3 d'arrêt à une planarisation ultérieure. Cette couche d'arrêt 3 est par exemple en nitrure de silicium et peut avoir une épaisseur de 0,2 µm.

On procède ensuite à la formation des cavités. Pour cela, on procède à une lithographie et à une gravure des couches 3 et 2 et à une gravure DRIE du substrat de silicium 1 pour obtenir des cavités 4 ayant par exemple une profondeur de 0,3 µm dans le substrat 1 (voir la figure 1B). La gravure du substrat 1 (gravure sèche ou gravure humide) est isotrope et sélective par rapport à la couche de protection monocristalline 2. On peut également alterner gravure anisotrope et gravure isotrope. Pour cette gravure sélective, on peut se référer à l'article « Characterization of a SiGe layer after isotropic etching of surrounding Si » de S. BOREL et al., SiGe Technology and Device Meeting 2006, ISTDM 2006, Third International, 15-17 mai 2006.

On procède ensuite à une gravure isotrope du substrat 1, sélective par rapport à la couche de protection 2 et à la couche d'arrêt 3. On obtient alors (voir la figure 1C) des cavités 5 de taille augmentée et présentant un surplomb 6 sur les bords des cavités 5. Le dépassement de surplomb 6 au-dessus de la cavité 5 peut être de 1 µm.

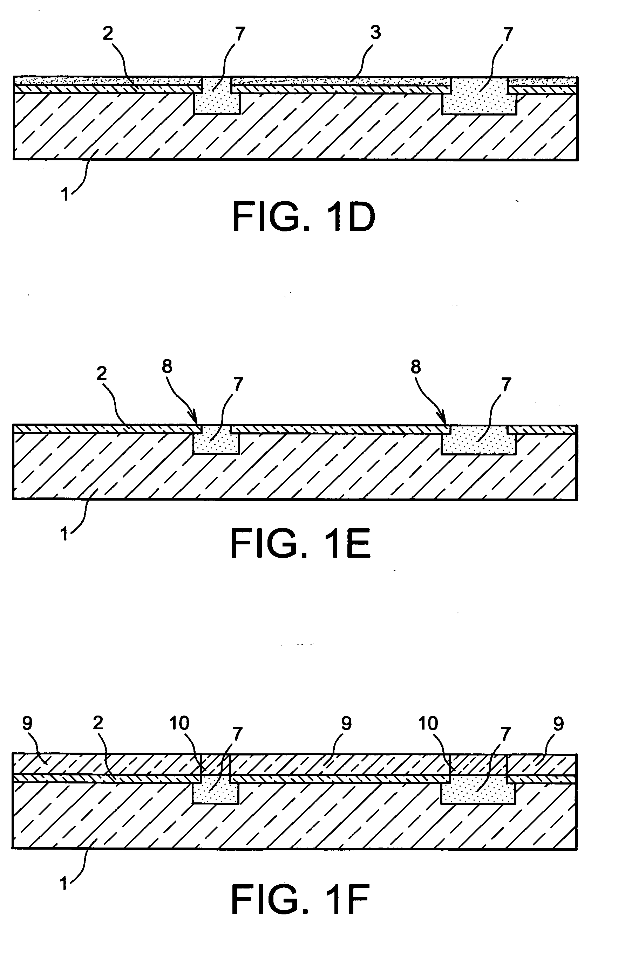

Les cavités 5 sont ensuite comblées par dépôt d'un matériau isolant, par exemple de l'oxyde de silicium ou du nitrure de silicium. Les cavités sont alors remplies de matériau électriquement isolant 7. On réalise ensuite un polissage mécano-chimique (CMP) avec arrêt sur la couche d'arrêt 3 (voir la figure 1D).

La couche d'arrêt 3 est alors gravée en même temps que le matériau remplissant les cavités et situé au même niveau que la couche d'arrêt 3. On obtient la structure représentée à la figure 1E qui montre le matériau électriquement isolant 7 faisant saillie hors des cavités et la couche de protection 2 formant surplomb dans les parties en retrait du matériau électriquement isolant 7.

Sur la structure obtenue, on forme par épitaxie une couche de silicium. Cette couche épitaxiée comprend (voir la figure 1F) des parties monocristallines 9 aux endroits où sa croissance s'est faite au-dessus de la couche de protection 2 et des parties polycristallines 10 aux endroits où sa croissance s'est faite au-dessus du matériau électriquement isolant 7. L'épaisseur de la couche épitaxiée peut être comprise entre 1 et 5 µm.

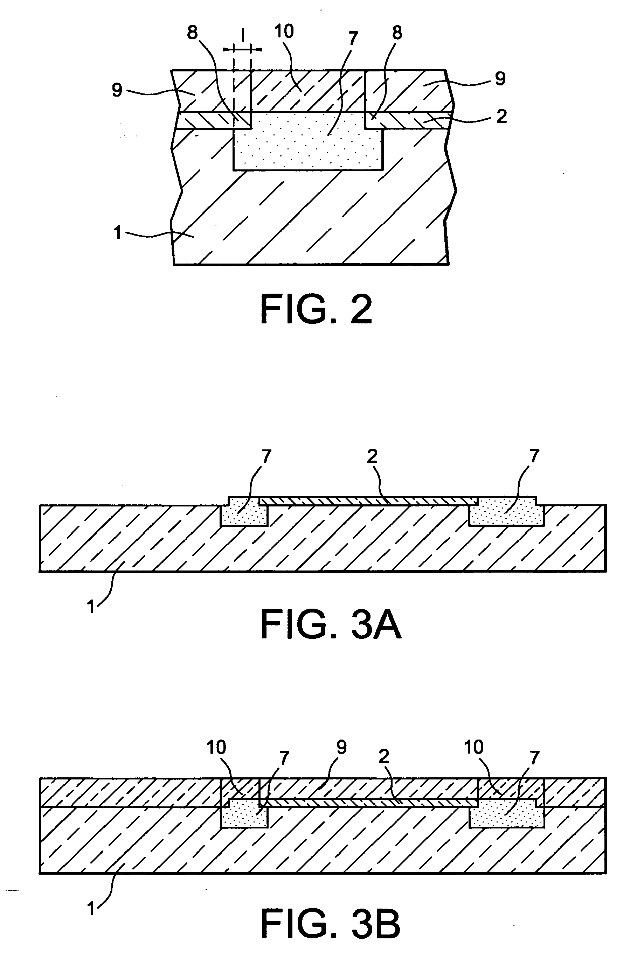

La figure 2 est une vue agrandie d'un détail de la figure 1F. Elle montre plus précisément les surplombs 8 au-dessus de la partie en matériau isolant 7 logée dans le substrat 1. La portion de la largeur l, au-dessus du substrat 1, est monocristalline (en SiGe ou en Si).

Bien évidemment, des étapes intermédiaires peuvent être intercalées dans l'enchaînement des étapes qui viennent d'être décrites pour réaliser une partie du MEMS ou dans le cas de variantes technologiques. Ainsi, il est possible de graver la couche de protection monocristalline avant épitaxie dans des zones que l'on ne souhaite pas libérer. Cet exemple est illustré par les figures 3A et 3B.

La figure 3A fait dans ce cas suite à la figure 1E. La couche de protection 2 a été gravée localement pour ne la laisser subsister qu'entre les pavés de matériau isolant 7. Chaque pavé 7 ne comprend alors qu'un seul surplomb en matériau monocristallin.

On procède ensuite à l'épitaxie de silicium pour obtenir la structure montrée à la figure 3B. Cette couche épitaxiée comprend une partie monocristalline 9 à l'endroit où sa croissance s'est faite au-dessus de la couche de protection 2 et des parties polycristallines 10 aux endroits où sa croissance s'est faite au-dessus du matériau électriquement isolant 7. Sur la partie découverte du substrat, le matériau monocristallin qui s'est développé se confond avec le substrat.

Il est également possible de réaliser des ancrages de différentes profondeurs ou en différents matériaux en procédant à autant de gravures de cavités, de remplissages et d'étapes de gravure / CMP des ancrages que nécessaire.

Le procédé est ensuite poursuivi de manière classique pour réaliser le composant MEMS désiré. On va maintenant décrire trois variantes de réalisation.

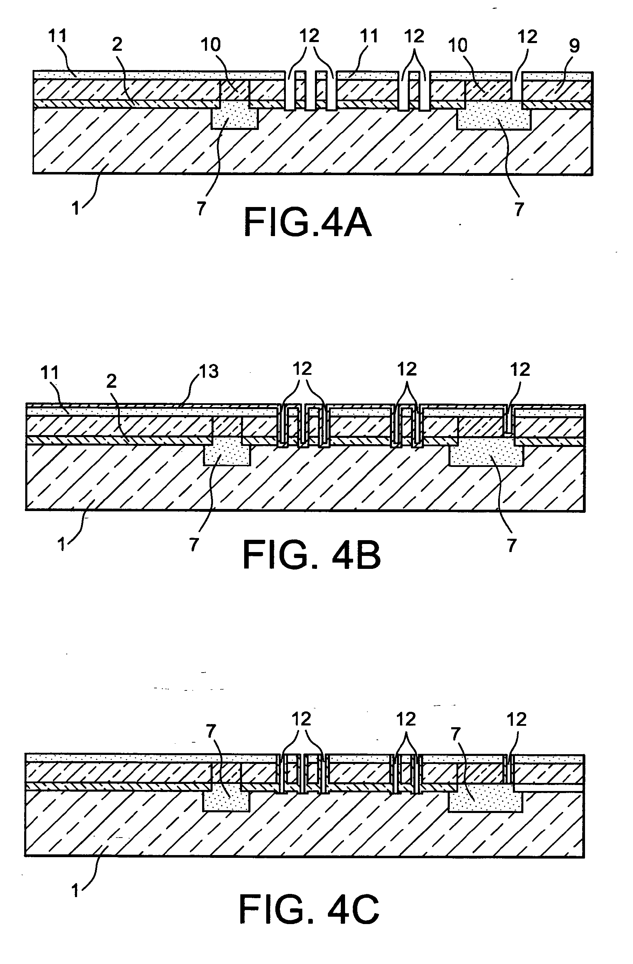

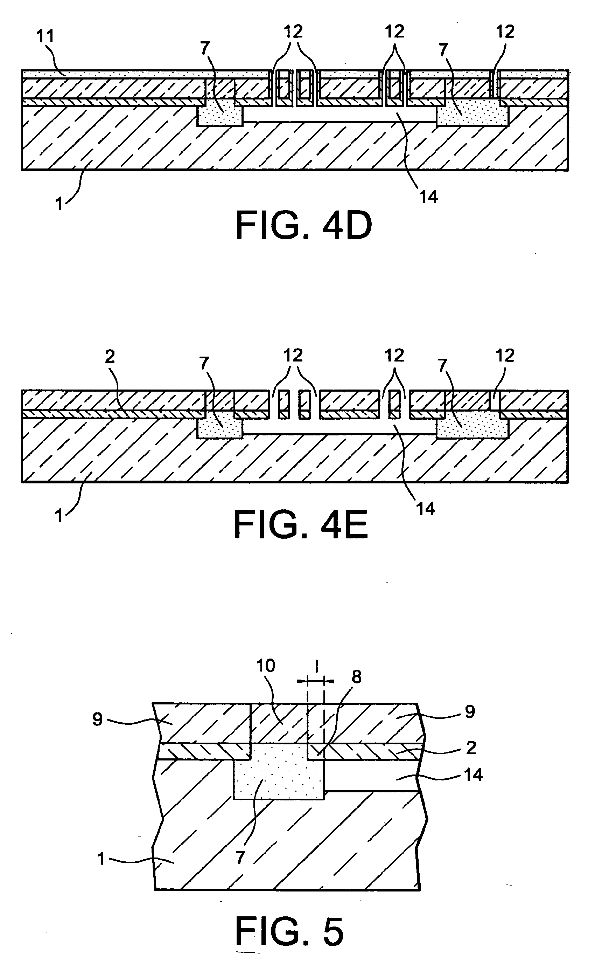

Les figures 4A et 4E illustrent les dernières étapes du procédé selon la présente invention en mettant en oeuvre la technologie MON pour "MEMS On Nothing".

La figure 4A fait suite à la figure 1F. Sur la couche de silicium comprenant les parties 9 et 10, on a formé une couche d'oxyde de silicium 11. On procède ensuite à une lithogravure DRIE du silicium et du SiGe de la structure pour obtenir des voies d'accès (tranchées, trous) 12 jusqu'au substrat massif 1.

On dépose ensuite, par épitaxie, une couche de SiGe 13 (voir la figure 4B) de 70 nm d'épaisseur par exemple et comportant typiquement de 20 à 30% de germanium, sur la structure obtenue précédemment. La couche 13 est polycristalline lorsque sa croissance s'effectue sur la couche de SiO₂ 11 et sur les parois des voies d'accès 12 gravées dans du matériau polycristallin (parties 10) ou isolant (pavé 7). La croissance est monocristalline, sur les parois des voies d'accès 12, lorsque sa croissance s'effectue sur les matériaux monocristallins des parties 9, de la couche de SiGe 2 et du substrat 1.

On procède ensuite à une gravure anisotrope de la couche de SiGe 13 jusqu'à exposer la couche de SiO₂ 11 (voir la figure 4C). Les flancs des voies d'accès 12 restent couverts de SiGe alors que leur fond expose le silicium monocristallin du substrat 1 ou le matériau isolant du pavé 7, le cas échéant.

On procède ensuite à une gravure isotrope du silicium du substrat 1, sélective par rapport au SiGe, grâce aux voies d'accès 12 pour libérer l'élément mécanique flexible. Cette gravure fournit une cavité 14, de profondeur comprise entre 1 µm et 2 µm, limitée par les zones d'ancrage 7 comme le montre la figure 4D. On peut alors procéder à la gravure de la couche de SiO₂ 11. Eventuellement, la couche de SiGe recouvrant les parois des voies d'accès 12 peuvent aussi être éliminées par gravure (voir la figure 4E). On prendra soin, lors de cette dernière gravure, de ne pas éliminer le SiGe de la zone d'ancrage.

L'une des zones d'ancrage est montrée agrandie sur la figure 5. Elle montre plus précisément un surplomb 8 au-dessus de la partie en matériau isolant 7. La portion de la largeur l au-dessus du pavé 7 est monocristalline (en SiGe ou en Si).

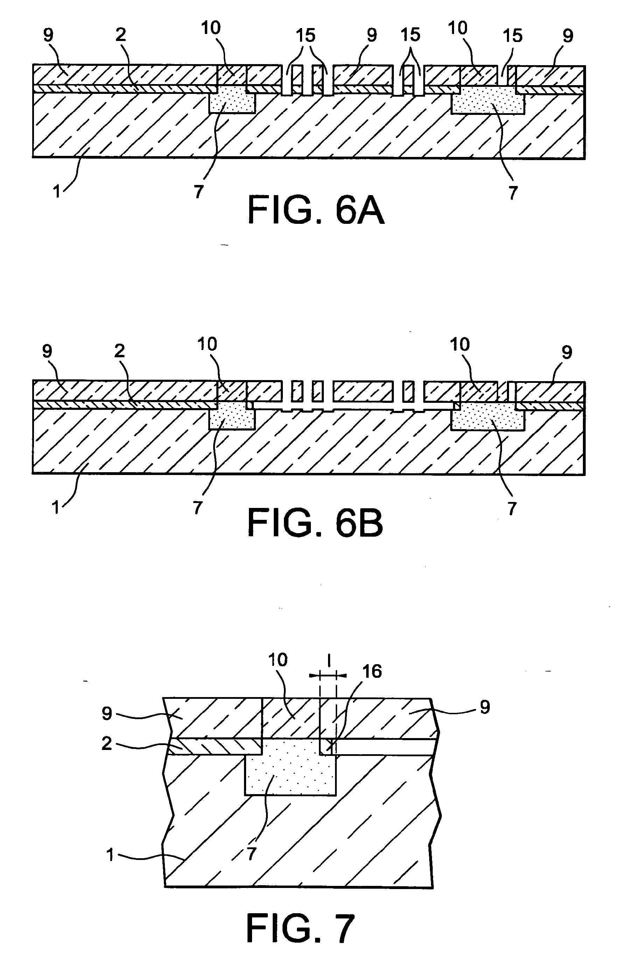

Les figures 6A et 6B illustrent les dernières étapes du procédé selon la présente invention en mettant en oeuvre la technologie SON.

La figure 6A fait suite à la figure 1F. On procède à une lithographie et à une gravure DRIE des couches superposées 9 (en silicium) et 2 (en SiGe) pour obtenir des voies d'accès 15 jusqu'au substrat massif 1.

A partir des voies d'accès 15, on grave la couche de SiGe 2 sélectivement par rapport au silicium environnant la couche 2. Cette gravure peut être une gravure sèche. Elle permet la libération de l'élément mécanique flexible. Il s'agit d'une gravure partielle en ce sens que la gravure a été menée pour qu'il subsiste une partie de la couche de SiGe en surplomb sur les pavés 7. C'est ce que montre la figure 6B.

L'une des zones d'ancrage est montrée agrandie sur la figure 7. Elle montre plus précisément un surplomb 16 au-dessus de la partie (ou pavé) en matériau isolant 7. La portion de largeur l au-dessus du pavé 7 est monocristalline (en SiGe ou en Si).

Dans ce mode de mise en oeuvre, la gravure de la couche SiGe 2 se fait au temps puisqu'une partie de ce matériau doit subsister entre l'oxyde des pavés d'isolation 7 et la partie de la couche de silicium 9, afin que l'ancrage soit bien monocristallin.

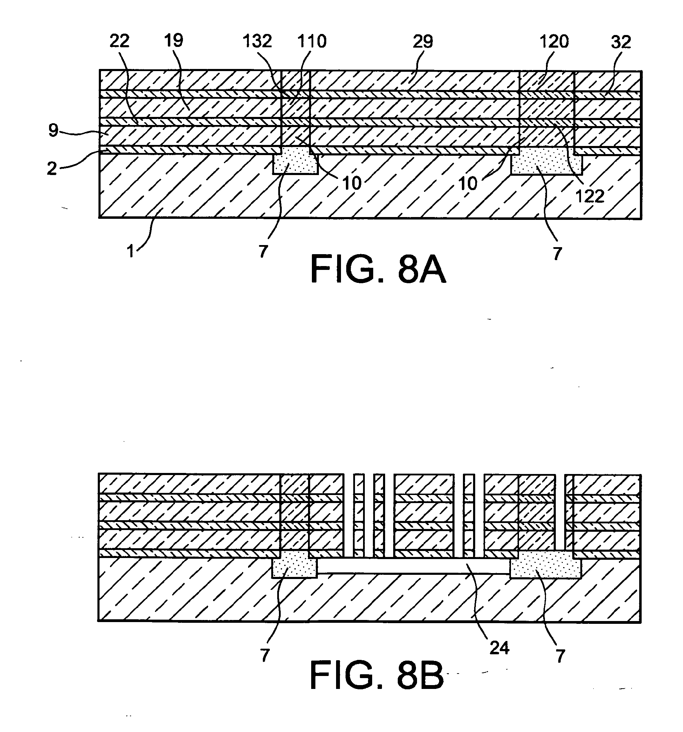

Les figures 8A et 8B illustrent les dernières étapes du procédé selon la présente invention en mettant en oeuvre la technologie MON et utilisant un empilement de couches épitaxiées.

La figure 8A fait suite à la figure 1E. A partir de la structure illustrée par la figure 1E, on forme par épitaxie une alternance de couches de silicium et de couches de SiGe pour obtenir, par exemple, la structure illustrée par la figure 8A. Cette figure montre, sur la couche de SiGe 2 laissant affleurer les pavés 7 en SiO₂, la succession de couches suivantes :
- une couche de silicium comprenant des parties monocristallines 9 (épitaxiées sur du SiGe monocristallin de la couche 2) et des parties polycristallines 10 (épitaxiées sur le SiO₂ des pavés 7), commue pour la figure 1F ;
- une couche de SiGe comprenant des parties monocristallines 22 (épitaxiée sur les parties en silicium polycristallin 9) et des parties polycristallines 122 (épitaxiées sur les parties en silicium polycristallin 10);
- une couche de silicium comprenant des parties monocristallines 19 (épitaxiées sur les parties de SiGe monocristallin 22) et des parties polycristallines 110 (épitaxiées sur les parties en SiGe polycristallin 122) ;
- une couche de SiGe comportant des parties monocristallines 32 (épitaxiées sur les parties en silicium monocristallin 19) et des parties polycristallines 132 (épitaxiées sur les parties en silicium polycristallin 110) ;
- une couche de silicium comprenant des parties monocristallines 29 (épitaxiées sur les parties de SiGe monocristallin 32) et des parties polycristallines 120 (épitaxiées sur les parties en SiGe polycristallin 132).

La suite des étapes est similaire aux étapes illustrées par les figures 4A et 4E. La figure 8B montre la structure finale obtenue, avec la cavité 24 limitée par les zones d'ancrage 7 et un ancrage monocristallin constitué d'un surplomb de couches monocristallines empilées en SiGe ou en Si.

Parmi les avantages procurés par l'invention, on peut citer les avantages suivants. L'empilement technologique repose sur des étapes technologiques classiques de la microélectronique et utilise un substrat standard. Le procédé selon l'invention est compatible CMOS et s'applique parfaitement aux technologies SON et MON. Les ancrages sont électriquement isolés si les cavités d'ancrage sont remplies d'un matériau diélectrique. L'encastrement de l'élément mécanique flexible est monocristallin. Il en résulte moins de pertes mécaniques (d'où un meilleur facteur de qualité des composants) et une meilleure tenue aux chocs. Les ancrages (isolants ou non) sont réalisés dans du silicium et peuvent servir d'arrêt de gravure lors de l'étape de libération de l'élément mécanique flexible. Il en résulte un meilleur contrôle de l'étape de libération (pas de risque de surgravure par exemple) et un accès à des motifs variés. La forme des éléments libérés n'est plus limitée par la nature isotrope de la gravure de libération. Il est alors possible de réaliser des membranes suspendues carrées ou hexagonales et non seulement circulaires.

Le procédé selon l'invention peut être utilisé pour toutes les applications MEMS et NEMS. Il met en oeuvre une technologie adaptée aux marchés bas coût et grands volumes : téléphonie mobile, automobile, jeux, ... . A titre d'exemple, on peut citer :
- pour les automobiles : les accéléromètres, les gyromètres, les capteurs de pression, les capteurs chimiques à base de résonateurs mécaniques MEMS ou NEMS,
- pour la téléphonie mobile : les bases de temps (résonateurs RF), les filtres mécaniques MEMS ou NEMS, les accéléromètres, les microphones,
- pour les jeux : les accéléromètres, les gyromètres.

## Revendications

1. Procédé de réalisation d'une structure MEMS/NEMS à partir d'un substrat (1) comportant au moins une partie en matériau semi-conducteur monocristallin, la structure comprenant un élément mécanique flexible rattaché à ladite partie du substrat par au moins une zone d'ancrage, le procédé comprenant les étapes suivantes :
- une étape de formation d'une première couche de protection (2) en matériau monocristallin sur une face libre de ladite partie du substrat (1), la première couche de protection étant en un matériau différent du matériau de ladite partie en matériau semi-conducteur monocristallin du substrat,
- une étape de gravure de la première couche de protection (2) et du substrat (1) pour réaliser au moins une cavité (5), la gravure étant menée pour laisser un surplomb (8) en matériau de la couche de protection sur les bords de la cavité,
- une étape de comblement de la cavité (5) par un matériau électriquement isolant (7) jusqu'à la face libre de la première couche de protection pour obtenir une partie d'ancrage isolante,
- une étape d'épitaxie comprenant l'épitaxie d'un matériau semi-conducteur à partir de la première couche de protection (2) et du matériau électriquement isolant (7) pour obtenir une couche destinée à la réalisation de l'élément mécanique flexible, la couche épitaxiée étant monocristalline (9) sur la première couche de protection (2) et polycristalline (10) sur le matériau électriquement isolant (7),
- une étape de libération de l'élément mécanique flexible par gravure, à travers un masque, d'au moins la première couche de protection, la gravure laissant subsister au moins une partie dudit surplomb (8).

2. Procédé selon la revendication 1, dans lequel l'étape de gravure de la première couche de protection et du substrat est réalisée :
- par une première étape de gravure de la première couche de protection et éventuellement du substrat, et
- par une deuxième étape de gravure consistant à graver le substrat de manière isotrope, cette gravure isotrope étant sélective par rapport à la première couche de protection.

3. Procédé selon la revendication 1, comprenant en outre les étapes suivantes :
- formation d'une couche d'arrêt (3) à une opération de planarisation, sur la première couche de protection (2), avant l'étape de gravure de la première couche de protection,
- gravure de la couche d'arrêt (3) pour réaliser la cavité (5),
- comblement de la cavité (5) faisant que le matériau électriquement isolant déborde de la face libre de la première couche de protection (2),
- opération de planarisation effectuée jusqu'à exposer la face libre de la première couche de protection.

4. Procédé selon la revendication 3, dans lequel l'opération de planarisation comprend un polissage mécano-chimique avec arrêt sur la couche d'arrêt (3) suivi d'une gravure de la couche d'arrêt et du matériau comblant la cavité jusqu'à exposer la face libre de la première couche de protection (2).

5. Procédé selon l'une quelconque des revendications 1 à 4, dans lequel l'étape de libération comprend, sur le matériau semi-conducteur (9, 10) épitaxié à partir de la première couche de protection (2) et du matériau électriquement isolant (7) :
- la formation d'une seconde couche de protection,
- la gravure, successivement, de la seconde couche de protection, du matériau semi-conducteur épitaxié et, éventuellement, de la première couche de protection pour définir l'élément mécanique flexible, et
- la formation d'une troisième couche de protection sur l'ensemble obtenu à l'étape précédente.

6. Procédé selon la revendication 5, dans lequel la deuxième couche de protection et la troisième couche de protection sont formées par dépôt ou par épitaxie.

7. Procédé selon l'une des revendications 5 ou 6, dans lequel l'étape de libération de l'élément mécanique comprend en outre la formation d'une cavité (14, 24) dans le substrat (1).

8. Procédé selon l'une quelconque des revendications 5 à 7, dans lequel l'étape de libération de l'élément mécanique comprend la gravure d'une partie de la troisième couche de protection et éventuellement une partie de la première couche de protection formée sur la face du substrat (1).

9. Procédé selon l'une quelconque des revendications 1 à 8, dans lequel ladite partie du substrat (1) est en silicium.

10. Procédé selon l'une quelconque des revendications 1 à 9, dans lequel la première couche de protection (2) est en SiGe.

11. Procédé selon l'une quelconque des revendications 1 à 10, dans lequel le matériau électriquement isolant (7) est choisi parmi SiO₂ et Si₃N₄.

12. Procédé selon l'une quelconque des revendications 1 à 11, dans lequel le matériau semi-conducteur épitaxié (9, 10) à partir de la première couche de protection (2) est en silicium.

13. Structure MEMS/NEMS comprenant un substrat (1) comportant au moins une partie en matériau semi-conducteur monocristallin et un élément mécanique flexible situé au-dessus d'une face de ladite partie du substrat, défini dans au moins une couche épitaxiée et rattaché au substrat par au moins une zone d'ancrage, la zone d'ancrage comprenant :
- une partie en matériau électriquement isolant (7) logée dans une cavité (5) du substrat (1) formée à partir de la face du substrat, la partie en matériau électriquement isolant (7) faisant saillie au-dessus de la face du substrat (1) en formant un retrait par rapport aux bords de la cavité (5),
- une partie en matériau semi-conducteur monocristallin comblant au moins partiellement ledit retrait en formant un surplomb (8),
- une partie appartenant à la couche épitaxiée constituée de matériau polycristallin (10) au-dessus de la saillie et de matériau monocristallin (9) au-dessus du surplomb.

14. Structure selon la revendication 13, dans laquelle ladite partie du substrat (1) est en silicium.

15. Structure selon l'une des revendications 13 ou 14, dans laquelle le matériau électriquement isolant (7) et choisi parmi SiO₂ et Si₃N₄.

16. Structure selon l'une quelconque des revendications 13 à 15, dans laquelle au moins une couche épitaxiée est en silicium.

## Claims

1. A method for producing a MEMS/NEMS structure from a substrate (1) comprising at least one portion made in a monocrystalline semiconductor material, the structure comprising a flexible mechanical element connected to said portion of the substrate by at least one anchoring zone, the method comprising the following steps:
- a step for formation of a first protection layer (2) in a monocrystalline material on a free face of said portion of the substrate (1), the first protection layer being made in a different material from that of said substrate potion made in monocrystalline semiconductor material,
- a step for etching of the first protection layer (2) and the substrate (1) in order to product at least one cavity (5), the etching being conducted so as to leave an overhang (8) in the material of the protection layer on the edges of the cavity,
- a step for filling of the cavity (5) by an electrically insulating material (7) up to the free face of the first protection layer in order to obtain an insulating anchoring portion,
- an epitaxy step including the epitaxy of a semiconductor material from the first protection layer (2) and the electrically insulating material (7) in order to obtain a layer designed for the production of a flexible mechanical element, the epitaxied layer being monocrystalline (9) on the first protection layer (2) and polycrystalline (10) on the electrically insulating material (7),
- a step for releasing the flexible mechanical element by etching, through a mask, from at least the first protection layer, the etching allowing at least one portion of said overhang (8) to remain.

2. The method according to claim 1, wherein the step for etching of the first protection layer and the substrate is done:
- by a first step for etching of the first protection layer and possibly of the substrate, and
- by a second etching step consisting of isotropically etching the substrate, this isotropic etching being selective in relation to the first protection layer.

3. The method according to claim 1, also including the following steps:
- formation of a stopping layer (3) from a planarization operation, on the first protection layer (2), before the step for etching of the first protection layer,
- etching of the stopping layer (3) in order to produce the cavity (5),
- filling of the cavity (5) making the electrically insulating material extend beyond the free face of the first protection layer (2),
- planarization operation conducted until the free face of the first protection layer is exposed.

4. The method according to claim 3, wherein the planarization operation comprises chemical-mechanical polishing with stopping on the stopping layer (3), followed by etching of the stopping layer and the material filling in the cavity until the free face of the first protection layer (2) is exposed.

5. The method according to any one of claims 1 to 4 wherein the releasing step includes, on the semiconductor material (9, 10) epitaxied from the first protection layer (2) and the electrically insulating material (7):
- the formation of a second protection layer,
- the etching, successively, of the second protection layer, the epitaxied semiconductor material and, eventually, the first protection layer in order to define the flexible mechanical element, and
- the formation of a third protection layer on the assembly obtained in the preceding step.

6. The method according to claim 5, wherein the second protection layer and the third protection layer are formed by deposition or epitaxy.

7. The method according to one of claims 5 or 6, wherein the step for releasing the mechanical element also includes the formation of a cavity (14, 24) in the substrate (1).

8. The method according to any one of claims 5 to 7, wherein the step for releasing the mechanical element includes the etching of a portion of the third protection layer and eventually a portion of the first protection layer formed on the face of the substrate (1).

9. The method according to any one of claims 1 to 8, wherein said portion of the substrate (1) is made in silicon.

10. The method according to any one of claims 1 to 9, wherein the first protection layer (2) is made in SiGe.

11. The method according to any one of clams 1 to 10, wherein the electrically insulating material (7) is chosen among SiO₂ and Si₃N₄.

12. The method according to any one of claims 1 to 11, wherein the epitaxied semiconductor material (9, 10) from the first protection layer (2) is in silicon.

13. A MEMS/NEMS structure comprising a substrate (1) including at least one portion made in monocrystalline semiconductor material and a flexible mechanical element locate above a face of said portion of the substrate, defined in at least one epitaxied layer and attached to the substrate by at least one anchoring zone, the anchoring zone comprising:
- a portion made in electrically insulating material (7) housed in a cavity (5) of the substrate (1) formed from the face of the substrate, the portion in electrically insulating material (7) protecting above the face of the substrate (1) while forming a recess in relation to the edges of the cavity (5),
- a portion made in monocrystalline semiconductor material at least partially filling in said recess while forming an overhang (8),
- a portion belonging to the epitaxied layer made up of polycrystalline material (10) above the protection and monocrystalline material (9) above the overhang.

14. The structure according to claim 13, wherein said portion of the substrate (1) is made in silicon.

15. The structure according to one of claims 13 or 14, wherein the electrically insulating material (7) is chosen among SiO₂ and Si₃N₄.

16. The structure according to any one of claims 13 to 15, wherein at least one epitaxied layer is made in silicon.

## Patentansprüche

1. Verfahren zur Herstellung einer MEMS/NEMS-Struktur, ausgehend von einem Substrat (1), das wenigstens einen Teil aus einem monokristallinen Halbleitermaterial umfasst, wobei die Struktur ein mechanisches flexibles Element umfasst, das an dem Teil des Substrats durch wenigstens einen Verankerungsbereich befestigt ist, wobei das Verfahren die folgenden Schritte umfasst:
- einen Schritt der Bildung einer ersten Schutzschicht (2) aus einem monokristallinen Material auf einer freien Oberfläche von dem Teil des Substrats (1), wobei die erste Schutzschicht aus einem Material besteht, welches von dem Material des Teils des Substrats aus einem monokristallinen Halbleitermaterial verschieden ist,
- einen Schritt des Ätzens der ersten Schutzschicht (2) und des Substrats (1), um wenigstens eine Kavität (5) herzustellen, wobei das Ätzen so durchgeführt wird, das ein Überhang (8) aus einem Material der Schutzschicht auf den Rändern der Kavität belassen wind,
- einen Schritt des _{A}uffüₗlens der Kavität (5) mit einem elektrisch isolierenden Material (7) bis zu der freien Oberfläche von der ersten Schutzschicht, um einen isolierenden Verankerungsteil zu erhalten,
- einen Epitaxie-Schritt, der die Epitaxie von einem Halbleitermaterial umfaßt, auf der ersten Schutzschicht (2) und dem elektrischen isolierenden Material (7), um eine Schicht zu erhalten, die zu der Herstellung des mechanischen flexiblen Elements bestimmt ist, wobei die epitaktische Schicht auf der ersten Schutzschicht (2) monokristallin (9) ist und auf dem elektrischen isolierenden Material (7) polykristallin (10) ist,
- einen Schritt der Loslösung des mechanischen flexiblen Elements wenigstens von der ersten Schutzschicht, durch Ätzen über eine Maske, wobei das Ätzen wenigstens einen Teil des Überhangs (8) bestehen lässt.

2. Verfahren nach Anspruch 1, wobei der Schritt des Ätzens der ersten Schutzschicht und des Substrats ausgeführt wird:
- durch einen ersten Schritt des Ätzens der ersten Schutzschicht und gegebenenfalls des Substrats, und
- durch einen zweiten Schritt des Ätzens, der darin besteht, das Substrat in isotroper Weise zu ätzen, wobei dieses isotrope Ätzen selektiv in Bezug auf die erste Schutzschicht ist.

3. Verfahren nach Anspruch 1, weiter umfassend die folgenden Schritte:
- Bilden einer Stopp-Schicht (3) für ein Planarisierungsverfahren auf der ersten Schutzschicht (2), vor dem Schritt des Ätzens der ersten Schutzschicht (2),
- Ätzen der Stopp-Schicht (3), um die Kavität (5) herzustellen,
- Füllen der Kavität (5) wobei bewirkt wird, dass das elektrisch isolierende Material über die freie Oberfläche der ersten Schutzschicht (2) hinaus tritt,
- ein Planarisierungs-Verfahren, durchgeführt bis zum Freilegen der freien Oberfläche der ersten Schutzschicht.

4. Verfahren nach Anspruch 3, wobei das Planarisierungs-Verfahren ein mechanisch-chemisches Polieren umfaßt, mit Stopp auf der Stopp-Schicht (3), gefolgt von einem Ätzen der Stopp-Schicht und des Materials, welches die Kavität füllt, bis die freie Oberfläche der ersten Schutzschicht (2) freigelegt ist.

5. Verfahren nach einem der Ansprüche 1 bis 4, wobei der Schritt des Loslösens umfasst, auf dem epitaktischen Halbleitermaterial (9, 10) auf der ersten Schutzschicht (2) und dem elektrischen isolierenden Material (7):
- eine zweite Schutzschicht zu bilden,
- nacheinander die zweite Schutzschicht, das epitaktische Halbleitermaterial und gegebenenfalls die erste Schutzschicht zu ätzen, um das mechanische flexible Element zu definieren, und
- eine dritte Schutzschicht auf der Gesamtheit zu bilden, die im vorhergehenden Schritt erhalten wurde.

6. Verfahren nach Anspruch 5, wobei die zweite Schutzschicht und die dritte Schutzschicht durch Deposition oder Epitaxie gebildet werden.

7. Verfahren nach einem der Ansprüche 5 oder 6, wobei der Schritt des Loslösens des mechanischen Elements weiterhin das Bilden einer Kavität (14, 24) in dem Substrat (1) umfasst.

8. Verfahren nach einem der Ansprüche 5 bis 7, wobei der Schritt des Loslösens des mechanischen Elements das Ätzen von einem Teil der dritten Schutzschicht und gegebenenfalls von einem Teil der ersten Schutzschicht umfasst, der auf der Oberfläche von dem Substrat (1) gebildet ist.

9. Verfahren nach einem der Ansprüche 1 bis 8, wobei der Teil von dem Substrat (1) aus Silizium besteht.

10. Verfahren nach einem der Ansprüche 1 bis 9, wobei die erste Schutzschicht (2) aus SiGe besteht.

11. Verfahren nach einem der Ansprüche 1 bis 10, wobei das elektrisch isolierende Material (7) ausgewählt ist aus SiO₂ und Si₃N₄.

12. Verfahren nach einem der Ansprüche 1 bis 11, wobei das epitaktische Halbleitermaterial (9, 10) auf der ersten Schutzschicht (2) aus Silizium besteht.

13. MEMS/NEMS-Struktur, umfassend ein Substrat (1), das wenigstens einen Teil aus einem monokristallinen Halbleitermaterial umfasst und ein mechanisches flexibles Element umfasst, welches sich oberhalb von einer Oberfläche von dem Teil des Substrats befindet, in wenigstens einer epitaktischen Schicht definiert und an dem Substrat vermittels eines Verankerungsbereichs befestigt ist, wobei der Verankerungsbereich umfasst:
- einen Teil aus einem elektrisch isolierenden Material (7), der in einer Kavität (5) von den Substrat (1) aufgenommen ist, die ausgehend von der Oberfläche des Substrats gebildet ist, wobei der Teil aus dem elektrischen isolierenden Material (7) einen über die Oberfläche des Substrats (1) hervor stehenden Vorsprung bildet, wobei er einen Rücksprung in Bezug auf die Ränder der Kavität (5) bildet,
- einen Teil aus einem monokristallinen Halbleitermaterial, der wenigstens teilweise den Rücksprung füllt und dabei einen Überhang (8) bildet,
- einen Teil, der zu der epitaktischen Schicht gehört, gebildet aus polykristallinem Material (10) oberhalb von dem Vorsprung und aus monokristallinem Material (9) oberhalb des Überhang.

14. Struktur nach Anspruch 13, wobei der Teil von dem Substrat (1) aus Silizium besteht.

15. Struktur nach einem der Ansprüche 13 oder 14, wobei das elektrisch isolierende Material (7) ausgewählt ist aus SiO₂ und Si₃N₄.

16. Struktur nach einem der Ansprüche 13 bis 15, wobei wenigstens eine epitaktische Schicht aus Silizium besteht.
